# EUROPÄISCHE PATENTANMELDUNG

(11) **EP 4 528 306 A1**
(43) Veröffentlichungstag der Anmeldung: **26.03.2025**
(21) Anmeldenummer: 23199170.4
(22) Anmeldetag: 22.09.2023
(51) Int. Cl.: G01R 33/565, G01R 33/48, G01R 33/56

(54) **COMPUTERIMPLEMENTIERTES VERFAHREN ZUR ERMITTLUNG EINER KORREKTURINFORMATION UND ZUR REKONSTRUKTION VON BILDDATEN EINER MAGNETRESONANZBILDGEBUNG, VERARBEITUNGSVORRICHTUNG UND COMPUTERPROGRAMM**

(71) Anmelder: Siemens Healthineers AG, 91301 Forchheim (DE)
(72) Erfinder: Köhler, Michael, 90408 Nürnberg (DE); Meixner, Christian, 91054 Erlangen (DE); Müller, Max, 91052 Erlangen (DE); Nickel, Marcel Dominik, 91074 Herzogenaurach (DE); Paul, Dominik, 91088 Bubenreuth (DE)
(74) Vertreter: Siemens Healthineers Patent Attorneys

(57) **Zusammenfassung**

Verfahren zur Ermittlung einer Korrekturinformation (1), zur Korrektur einer Magnetresonanzbildgebung, umfassend die Schritte:
- Erfassen von jeweiligen ersten und zweiten Magnetresonanzdaten (7, 8) für wenigstens eine Gradientenrichtung (5, 6),
• wobei die ersten Magnetresonanzdaten (7) erfasst werden, während das Untersuchungsvolumen (2) mit dem Magnetfeldgradient (3) in die jeweilige Gradientenrichtung (5, 6) beaufschlagt wird, und
• wobei die zweiten Magnetresonanzdaten (8) erfasst werden, während das Untersuchungsvolumen (2) mit dem Magnetfeldgradient (4) entgegen der jeweiligen Gradientenrichtung (5, 6) beaufschlagt wird,

- Ermitteln einer jeweiligen Phasendifferenz (9) für mehrere Referenzpunkte (10) entlang einer jeweiligen Ortsraumlinie (11) im Ortsraum (12), die in die jeweilige Gradientenrichtung (5, 6) verläuft, auf Basis der ersten und zweiten Magnetresonanzdaten (7, 8), und
- Bereitstellen der Phasendifferenzen (9) von zumindest einer Untergruppe der Referenzpunkte (10) als Korrekturinformation (1) oder Ermitteln der bereitgestellten Korrekturinformation (1) in Abhängigkeit der Phasendifferenzen (9) zumindest der Untergruppe (19) der Referenzpunkte (10).

## Beschreibung

Die Erfindung betrifft ein computerimplementiertes Verfahren zur Ermittlung einer Korrekturinformation, die zur Korrektur von Abbildungsfehlern einer Magnetresonanzbildgebung dient und die Feldinhomogenitäten des Magnetfeldes in einem Untersuchungsvolumen betrifft, die durch das Beaufschlagen des Untersuchungsvolumens mit einem Magnetfeldgradienten in wenigstens eine Gradientenrichtung resultieren. Zudem betrifft die Erfindung ein computerimplementiertes Verfahren zur Rekonstruktion von Bilddaten einer Magnetresonanzbildgebung, eine Verarbeitungsvorrichtung und ein Computerprogramm.

Die Magnetresonanzbildgebung ist eine, insbesondere im medizinischen Bereich, inzwischen gängige Bildgebungsmodalität. Während Aufnahmetrajektorien, mit denen der k-Raum kartesisch abgetastet wird, bekannt sind und häufig eingesetzt werden, wurden inzwischen auch nicht-kartesische Aufnahmetrajektorien vorgeschlagen. Beispielsweise werden radiale Messsequenzen genutzt, in denen nacheinander einzelne radiale Speichen (spokes) im k-Raum abgetastet werden.

Durch Gradientenpulse erzeugte Wirbelströme können in Magnetresonanzeinrichtungen zu zeitlich und räumlich veränderlichen Feldstörungen führen. Insbesondere bei nicht kartesischen Abtastschemata, die lineare Aufnahmetrajektorien in unterschiedlichen Ausleserichtungen nutzen, insbesondere also bei einer radialen Abtastung des k-Raums, können die resultierenden Feldinhomogenitäten zu erheblichen Artefakten in rekonstruierten Bilddaten führen, beispielsweise zu Ghosting oder zu lokalen Signalauslöschungen.

Zur Korrektur entsprechender Messdaten wurde im Stand der Technik vorgeschlagen, eine Verzögerungszeitkorrektur (delay time correction - DTC) anzuwenden, bei welcher durch Kalibriermessungen gewonnene Korrekturdaten genutzt werden, um Signalkurven, die für eine jeweilige Gradientenrichtung erfasst werden, in Abhängigkeit der Gradientenrichtung im k-Raum zu verschieben. Eine solche Korrektur wird beispielsweise in einem Artikel von Tess Armstrong et al., "Free-Breathing Liver Fat Quantification Using a Multiecho 3D Stack-of-Radial-Technique", Magn. Reson. Med. 79 (2018), Seiten 370-382, offenbart.

Durch eine Verschiebung im k-Raum beziehungsweise die erläuterte Verzögerungszeitkorrektur können allerdings nur gradientenartige beziehungsweise mit der Ausleserichtung zumindest näherungsweise linear variierende Feldstörungen kompensiert werden. Nichtlinear mit der Ausleserichtung variierende Feldbeiträge, beispielsweise Störungen zweiter und/oder dritter und/oder höherer Ordnung, können in einigen Bildgebungseinrichtungen beziehungsweise für bestimmte Messsequenzen jedoch ebenfalls zu deutlichen Bildstörungen führen.

Daher liegt der Erfindung die Aufgabe zugrunde, die Erkennung und insbesondere die Quantifizierung von ungewünschten Feldinhomogenitäten, die aus einer Gradientenbeaufschlagung des Untersuchungsbereichs, insbesondere aufgrund von Wirbelströmen, resultieren, weiter zu verbessern, um hierdurch Messdaten besser korrigieren zu können und somit die Bildqualität weiter zu verbessern.

Die Aufgabe wird erfindungsgemäße durch ein Verfahren eingangs genannter Art gelöst, dass die folgenden Schritte umfasst:
- Erfassen von jeweiligen ersten und zweiten Magnetresonanzdaten für wenigstens eine Gradientenrichtung,
   - wobei die ersten Magnetresonanzdaten erfasst werden, während das Untersuchungsvolumen mit dem Magnetfeldgradient in die jeweilige Gradientenrichtung beaufschlagt wird, und
   - wobei die zweiten Magnetresonanzdaten erfasst werden, während das Untersuchungsvolumen mit dem Magnetfeldgradient entgegen der jeweiligen Gradientenrichtung beaufschlagt wird,
- Ermitteln einer jeweiligen Phasendifferenz für mehrere Referenzpunkte entlang einer jeweiligen Ortsraumlinie im Ortsraum, die in die jeweilige Gradientenrichtung verläuft, auf Basis einer Differenz zwischen
   - einer ermittelten ersten Phase des Magnetresonanzsignals am jeweiligen Referenzpunkt, die auf Basis der ersten Magnetresonanzdaten ermittelte wird, und
   - einer ermittelten zweiten Phase des Magnetresonanzsignals am jeweiligen Referenzpunkt, die auf Basis der zweiten Magnetresonanzdaten ermittelt wird,
- Bereitstellen der Phasendifferenzen von zumindest einer Untergruppe der Referenzpunkte als Korrekturinformation oder Ermitteln der bereitgestellten Korrekturinformation in Abhängigkeit der Phasendifferenzen zumindest der Untergruppe der Referenzpunkte.

Zum besseren Verständnis des Verfahrens wird in der folgenden Erläuterung davon ausgegangen, dass der Betrag des Magnetfeldgradienten in Gradientenrichtung und des Magnetfeldgradienten entgegen der Gradientenrichtung gleich ist. Obwohl es sich hierbei um eine besonders vorteilhafte Ausgestaltung handelt, ist eine solche Einschränkung jedoch nicht notwendig erforderlich und eine zusätzliche Phasendifferenz, die aus der Nutzung unterschiedlicher Beträge der Magnetfeldgradienten resultieren würde, kann beispielsweise analytisch ermittelt und berücksichtigt werden. Die jeweilige Ortsraumlinie verläuft geradlinig in die jeweilige Gradientenrichtung und erstreckt sich vorzugsweise bis zum Zentrum des Messvolumens oder durch das Zentrum hindurch.

Eine Phasendifferenz ungleich null resultiert, abgesehen von in vielen Anwendungsfällen vernachlässigbaren beziehungsweise korrigierbaren Phasendifferenzen aufgrund einer Bewegung eines Untersuchungsobjekts oder von Teilen des Untersuchungsobjekts, im Wesentlichen vollständig aus Feldinhomogenitäten, die bei der Schaltung eines Gradienten beispielsweise aufgrund von Wirbelströmen auftreten können. Solche Feldinhomogenitäten führen zu einer Änderung der lokalen Feldstärke und somit zu einer Änderung der Larmorfrequenz der Spins, aus der über die Messzeit hinweg ein Phasenoffset resultiert.

Bei gegengleichen Magnetfeldgradienten kann davon ausgegangen werden, dass auch die resultierenden Feldinhomogenität, die bei der Erfassung der ersten und zweiten Magnetresonanzdaten auftreten, ebenfalls zumindest näherungsweise gegengleich sind, sodass im erfindungsgemäßen Verfahren auf Basis der ermittelten Phasendifferenz unmittelbar auf die die Stärke der lokalen Feldinhomogenität beziehungsweise der Abweichung vom Sollmagnetfeld aufgrund von Wirbelströmen oder anderen Effekten geschlossen werden kann.

Bei einem aktiven Magnetfeldgradienten auftretende zusätzliche Feldinhomogenitäten durch Wirbelströme oder Ähnliches führen dazu, dass empfangene Signale aufgrund des auftretenden Phasenfehlers bei einer üblichen Rekonstruktion dem falschen Ort zugeordnet werden. Dies kann dadurch vermieden werden, dass, wie später noch im Detail mit Bezug auf das erfindungsgemäße Verfahren zur Rekonstruktion von Bilddaten einer Magnetresonanzbildgebung erläutert werden wird, im Rahmen der Bildgebung erfasste Signalkurven, die jeweils den Verlauf einer k-Raum-Amplitude und/oder einer k-Raum-Phase des Magnetresonanzsignals entlang einer k-Raum-Linie in einem einer jeweiligen Messschicht zugeordneten zweidimensionalen k-Raum beschreiben, in den Ortsraum transformiert, dort auf Basis der Korrekturinformation entzerrt und anschließend in den k-Raum rücktransformiert werden, um korrigierte Signalkurven bereitzustellen, auf deren Basis dann eine Bildrekonstruktion erfolgen kann.

Treten hinreichend kleine Phasendifferenzen auf, so kann die Differenz der Phasen beziehungsweise, wie später noch erläutert werden wird, die halbe Differenz unmittelbar als Phasendifferenz verwendet werden. Anderenfalls kann es zweckmäßig sein, Phasensprünge aufgrund von Phasenüberläufen durch ein sogenanntes "Phase Unwrapping" zu vermeiden, wie später noch erläutert werden wird.

Bei Nutzung von gegengleichen Gradienten zur Ermittlung der ersten und zweiten Magnetresonanzdaten entspricht der Phasenfehler aufgrund des jeweils geschalteten Gradienten der Hälfte der ermittelten beziehungsweise durch ein "Phase Unwrapping" korrigierten Phasendifferenz, sodass dieses Zwischenergebnis insbesondere halbiert werden kann, um die Korrekturinformation bereitzustellen, wenn diese unmittelbaren den Phasenfehler bei der zur Ermittlung der Korrekturinformation genutzten Gradientenfeldstärke beschreiben soll.

Die Phasendifferenzen werden vorzugsweise für zwei gewinkelt zueinanderstehende Gradientenrichtungen ermittelt. Insbesondere können diese Gradientenrichtungen im Wesentlichen senkrecht zueinander stehen, beispielsweise in einem Winkel von wenigstens 60° oder wenigstens 80° zueinander. Durch das Erfassen von Phasendifferenzen für mehrere gewinkelt zueinander stehende Gradientenrichtungen können Feldinhomogenitäten, die aufgrund von Gradienten in beliebigen Richtungen innerhalb der durch die beiden Gradientenrichtungen aufgespannten Ebene liegen, zumindest näherungsweise abgeschätzt und somit korrigiert werden, wie später noch mit Bezug auf das erfindungsgemäße Rekonstruktionsverfahren genauer erläutert werden wird.

Statt einer unmittelbaren Verwendung der Phasendifferenzen zur Korrektur beziehungsweise als Korrekturinformation kann es zweckmäßig sein, aus diesen zunächst Korrekturparameter zu ermitteln. Eine vorgegebene Korrekturfunktion kann den Referenzpunkten entlang der jeweiligen Ortsraumlinie in Abhängigkeit wenigstens eines jeweiligen Korrekturparameters für die jeweilige Gradientenrichtung und der Position des jeweiligen Referenzpunktes entlang der jeweiligen Ortsraumlinie einen Phasendifferenzwert zuordnet. Der jeweilige Korrekturparameter kann dann ermittelt werden, indem ein Maß für die Abweichungen zwischen dem für den jeweiligen Referenzpunkt durch die Korrekturfunktion vorgegebenen Phasendifferenzwert und der für diesen Referenzpunkt ermittelten Phasendifferenz zumindest für jene Referenzpunkte entlang der jeweiligen Ortsraumlinie, die Teil der Untergruppe sind, durch Anpassung des Korrekturparameters minimiert wird. Die Korrekturinformation kann dann den wenigstens einen jeweiligen Korrekturparameter für die jeweilige Gradientenrichtung umfassen oder von diesem abhängen.

Durch die Nutzung eines oder mehrerer Korrekturparameter als Korrekturinformation können typische Feldinhomogenitäten mit einigen wenigen Korrekturparametern gut abgebildet werden, beispielsweise durch einen polynominalen Fit. Zudem kann hierdurch auch eine Vorgabe von Phasendifferenzwerten und somit eine Abschätzung von Feldinhomogenitäten für Abschnitte der Ortsraumlinie erfolgen, für die, wie später noch erläutert werden wird, im Rahmen der Korrekturermittlung keine hinreichend rauscharmen Phaseninformationen erfasst werden können, um dort direkt verlässliche Phasendifferenzen zu ermitteln. Zuletzt kann die Nutzung wenigstens eines Korrekturparameters die Interpolation von im Rahmen der Rekonstruktion der Bilddaten genutzten Korrekturgrößen erleichtern, die später noch erläutert werden wird.

Als die Korrekturfunktion kann ein Polynom wenigstens zweiten oder wenigstens dritten Grades in der Position des jeweiligen Referenzpunktes entlang der jeweiligen Ortsraumlinie als Variable verwendet werden, wobei wenigstens einer der Koeffizienten des Polynoms als Korrekturparameter verwendet wird. Für die meisten Anwendungen ist die Nutzung eines Polynoms dritten Grades ausreichend. Hierbei muss das Polynom nicht alle Potenzen der Variable umfassen. Beispielsweise kann das Polynom nur die erste und dritte Potenz der Variable umfassen. Als Korrekturparameter kann insbesondere zumindest der Koeffizient für die dritte Potenz der Variable, vorzugsweise der Koeffizient für alle im Polynom vorkommenden Potenzen der Variable, bestimmt werden.

Die Phasendifferenzen können für Referenzpunkte in mehreren in eine Schichtselektionsrichtung aufeinanderfolgenden Messschichten ermittelt werden, wobei einem jeweiligen Paar aus Korrekturparameter und Gradientenrichtung jeweils wenigstens ein Metakorrekturparameter zugeordnet ist, der als Teil der Korrekturinformation bereitgestellt wird oder von dem die Korrekturinformation abhängt, wobei durch eine vorgegebene Metakorrekturfunktion für das jeweilige Paar und die jeweilige Messschicht in Abhängigkeit des jeweiligen dem Paar zugeordneten Metakorrekturparameters und der Position der jeweiligen Messschicht in Schichtselektionsrichtung ein Korrekturwert vorgegeben wird. Der jeweilige Metakorrekturparameter kann ermittelt werden, indem der wenigstens eine jeweilige Korrekturparameter für die jeweilige Gradientenrichtung zunächst separat für jede Messschicht zumindest einer Untergruppe der Messschichten ermittelt wird, wonach für das jeweilige Paar aus Korrekturparameter und Gradientenrichtung jeweils ein Maß für die Abweichungen der für die verschiedenen Messschichten durch die Metakorrekturfunktion für dieses Paar vorgegebenen Korrekturwerte von dem jeweiligen für das Paar und die jeweilige Messschicht ermittelten Korrekturparameter zumindest für jene Messschichten, die Teil der Untergruppe sind, durch Anpassung des jeweiligen Metakorrekturparameters minimiert wird.

Anders ausgedrückt wird durch Anpassung der Metakorrekturparameter die Metakorrekturfunktion an den Verlauf der Korrekturwerte in Schichtselektionsrichtung gefittet, wobei optional ausschließlich die Korrekturwerte der Messschichten der Untergruppe berücksichtigt werden.

Zur Ermittlung der Phasendifferenzen für mehrere Messschichten können die Messschichten im einfachsten Fall separat angeregt werden. Vorzugsweise erfolgt im Rahmen der Messung jedoch eine Phasenkodierung in Schichtselektionsrichtung. Dies wird später noch im Detail erläutert.

Alternativ zur Ermittlung der Metakorrekturparameter kann die Phasendifferenzen für Referenzpunkte in mehreren in eine Schichtselektionsrichtung aufeinanderfolgenden Messschichten ermittelt werden, wobei der wenigstens eine jeweilige Korrekturparameter für die jeweilige Gradientenrichtung zunächst separat für jede Messschicht zumindest einer Untergruppe der Messschichten ermittelt wird, wodurch ein vorläufiger Parameterverlauf des jeweiligen Korrekturparameters in Schichtselektionsrichtung vorgegeben wird, wonach eine Glättungsfunktion diesen vorläufigen Parameterverlauf glättet, um einen jeweiligen geglätteten Parameterverlauf bereitzustellen, der als Teil der Korrekturinformation bereitgestellt wird oder von dem die Korrekturinformation abhängt.

Das Glätten des vorläufigen Parameterverlaufs kann beispielsweise durch einen Fit oder eine Filterung erfolgen und/oder dazu dienen, das Verwerfen von Schichten, die nicht Teil der Untergruppe sind, zu kompensieren.

In einer weiteren Alternative kann die Phasendifferenzen für Referenzpunkte in mehreren in eine Schichtselektionsrichtung aufeinanderfolgenden Messschichten ermittelt werden, wobei eine vorgegebene Korrekturfunktion den Referenzpunkten in einer jeweiligen Ebene, die durch die jeweilige Ortsraumlinie und die Schichtselektionsrichtung aufgespannt ist, in Abhängigkeit wenigstens eines jeweiligen Korrekturparameters für die jeweilige Gradientenrichtung und der Position des jeweiligen Referenzpunktes entlang der jeweiligen Ortsraumlinie und in Schichtselektionsrichtung einen Phasendifferenzwert zuordnet, wobei der jeweilige Korrekturparameter ermittelt wird, indem ein Maß für die Abweichungen zwischen dem für den jeweiligen Referenzpunkt durch die Korrekturfunktion vorgegebenen Phasendifferenzwert und der für diesen Referenzpunkt ermittelten Phasendifferenz zumindest für jene Referenzpunkte in der jeweiligen Ebene, die Teil der Untergruppe sind, durch Anpassung des Korrekturparameters minimiert wird, wobei die Korrekturinformation den wenigstens einen jeweiligen Korrekturparameter für die jeweilige Gradientenrichtung umfasst oder von diesem abhängt.

In diesem Fall wird für die Korrekturfunktion somit jeweils ein zweidimensionaler Fit sowohl in Schichtselektionsrichtung als auch in Richtung der jeweiligen Ortsraumlinie durchgeführt. Die Untergruppe der berücksichtigten Referenzpunkte kann insbesondere ausschließlich Referenzpunkte umfassen, die Teil einer Messschicht der Untergruppe der Messschichten sind. Zudem können, wie später noch erläutert werden wird, Referenzpunkte aus Bereichen mit geringer Signalamplitude unberücksichtigt bleiben.

Für den jeweiligen Referenzpunkt kann zusätzlich auf Basis der ersten und/oder zweiten Magnetresonanzdaten die oder eine Amplitude des Magnetresonanzsignals am jeweiligen Referenzpunkt ermittelt werden, wobei die Untergruppe der Schichten in Abhängigkeit der Amplituden der Referenzpunkte in der jeweiligen Messschicht ausgewählt wird.

Beispielsweise können ausschließlich Messschichten in die Untergruppe aufgenommen werden, für die der Mittelwert und/oder der Median der Amplituden aller Referenzpunkte in der jeweiligen Messschicht oder aller Referenzpunkte auf der jeweiligen Ortsraumlinie in der jeweiligen Messschicht einen jeweiligen vorgegebene Schichtgrenzwert erreicht oder überschreitet.

Alternativ oder ergänzend kann für die Aufnahme der jeweiligen Messschicht in die Untergruppe gefordert werden, dass für eine vorgegebene Anzahl oder einen vorgegebenen Anteil der Referenzpunkte die jeweilige Amplitude einen vorgegebenen Amplitudengrenzwert erreicht oder überschreitet.

In die Untergruppe können somit beispielsweise jene Messschichten aufgenommen werden, für die im Mittel beziehungsweise für hinreichend viele Referenzpunkte eine hinreichende Signalamplitude vorliegt. Dies ist zweckmäßig, da bei niedrigen Signalamplituden die ermittelte Phase ein geringes Signal-zu-Rauschverhältnis aufweisen kann, womit Bereiche des Messvolumens, aus denen geringe Signalstärken empfangen werden, beispielsweise Bereiche außerhalb des Untersuchungsobjekts, bei der Ermittlung der Korrekturinformation vorzugsweise unberücksichtigt bleiben.

Die Phasendifferenzen können für Referenzpunkte in mehreren Messschichten ermittelt werden, indem bei der Erfassung der jeweiligen ersten und zweiten Magnetresonanzdaten zusätzlich eine Phasenkodierung in die oder eine Schichtselektionsrichtung genutzt wird, wodurch die ersten und zweiten Magnetresonanzdaten zunächst in Schichtselektionsrichtung im Frequenzraum vorliegen, wonach durch eine Fouriertransformation der jeweiligen ersten und zweiten Messdaten in Schichtselektionsrichtung für unterschiedliche Positionen in Schichtselektionsrichtung und somit unterschiedliche Messschichten jeweils von den ersten Messdaten abhängige erste Teilmessdaten und von den zweiten Messdaten abhängige zweite Teilmessdaten für jede der Messschichten vorliegen, wonach für die Referenzpunkte entlang der jeweiligen Ortsraumlinie in der jeweiligen Messschicht die ersten Phasen des Magnetresonanzsignals auf Basis der jeweiligen ersten Teilmessdaten und die zweiten Phasen des Magnetresonanzsignals auf Basis der jeweiligen zweiten Teilmessdaten ermittelt werden.

Durch dieses vorgehen kann mit geringem Messaufwand eine voneinander unterschiedliche Korrektur der Messdaten für unterschiedliche Schichten genutzt werden beziehungsweise allgemein können auch Feldinhomogenitäten in Schichtselektionsrichtung berücksichtigt werden.

Die Schichtselektionsrichtung steht im Wesentlichen senkrecht auf der wenigstens einen Gradientenrichtung, beispielsweis in einem Winkel von wenigstens 70° oder wenigstens 80°.

Für den jeweiligen Referenzpunkt kann zusätzlich auf Basis der ersten und/oder zweiten Magnetresonanzdaten die oder eine Amplitude des Magnetresonanzsignals am jeweiligen Referenzpunkt ermittelt werden. Einerseits können ausschließlich Referenzpunkte in die Untergruppe der Referenzpunkte aufgenommen werden, für die die Amplitude einen Amplitudengrenzwert erreicht oder überschreitet. Andererseits können, bei einer Ermittlung der Phasendifferenzen für Referenzpunkte in mehreren in die oder eine Schichtselektionsrichtung aufeinanderfolgenden Messschichten, ergänzend oder alternativ Referenzpunkte, die auf einer jeweiligen Geraden in Schichtselektionsrichtung liegen, ausschließlich dann in die Untergruppe aufgenommen werden, wenn ein gemeinsamer Amplitudenwert, der auf Basis ihrer Amplituden ermittelt wird, einen Gruppengrenzwert erreicht oder überschreitet.

Es kann somit eine Art Gating für die Referenzpunkte durchgeführt werden, sodass beispielsweise für die obige erläuterte Bestimmung des Korrekturparameters nur Referenzpunkte mit hinreichend starkem Magnetresonanzsignal berücksichtigt werden. Dies ist zweckmäßig, da in Referenzpunkten mit sehr niedriger Amplitude des Magnetresonanzsignals die ermittelte Phase typischerweise im Wesentlichen durch einen Rauschanteil des Signals geprägt oder hierdurch zumindest deutlich gestört ist. Die Berücksichtigung entsprechender Phasen könnte somit die Korrekturqualität verringern, was jedoch durch die Auswahl der Untergruppe der Referenzpunkte vermieden werden kann.

Insbesondere dann, wenn eine Mittelung oder ein Fit über mehrere Messschichten durchgeführt werden soll, kann es zweckmäßig sein, Bereiche, in denen beispielsweise im Mittel über alle Schichten nur geringe Amplituden auftreten, nicht zu berücksichtigen. Als gemeinsamer Amplitudenwert kann insbesondere ein Mittelwert oder ein Median der Amplituden der auf der jeweiligen Geraden in Schichtselektionsrichtung liegenden Referenzpunkte ermittelt werden.

Es ist in vielen Anwendungsfällen ausreichend, die Amplitude ausschließlich auf Basis der ersten oder ausschließlich auf Basis der zweiten Magnetresonanzdaten zu ermitteln. Es ist jedoch beispielsweise auch möglich, eine jeweilige Teilamplitude auf Basis der ersten und zweiten Magnetresonanzdaten zu ermitteln und die zum Grenzwertvergleich herangezogene Amplitude beispielsweise durch Mittelung der Teilamplituden zu bestimmen. Es wäre jedoch beispielsweise auch möglich, jeweils eine separate Amplitude auf Basis der ersten und zweiten Magnetresonanzdaten zu ermitteln und beispielsweise nur Referenzpunkte in die Untergruppe aufzunehmen, für die beide Amplituden den Amplitudengrenzwert überschreiten oder Ähnliches.

In einigen Fällen kann es vorteilhaft sein, nicht alle Referenzpunkte in die Untergruppe aufzunehmen, deren Amplituden den Amplituden- beziehungsweise Gruppengrenzwert erreichen oder überschreiten. Ist beispielsweise bekannt, dass hinreichende Amplituden nur in einem zentralen Bereich des Messvolumens erwartet werden, beispielsweise weil ein dort befindliches Untersuchungsobjekt von Luft umgeben ist, kann es zweckmäßig sein, alle Referenzpunkte auf einer jeweiligen Ortsraumlinie, die weiter vom Zentrum des Untersuchungsbereichs beabstandet sind als ein Referenzpunkt auf dieser Ortsraumlinie, dessen Amplitude den Grenzwert unterschreitet, nicht in die Untergruppe aufzunehmen.

Die Phasendifferenzen für die jeweilige Ortsraumlinie können durch einen Phasenkorrekturalgorithmus ermittelt werden, der dazu eingerichtet ist, durch Analyse des Verlaufs der Differenz zwischen der ermittelten ersten und zweiten Phase entlang der jeweiligen Ortsraumlinie Phasensprünge aufgrund eines Phasenüberlaufs zu erkennen und zu korrigieren. Bei hinreichender Feldinhomogenität beziehungsweise Gradientenstärke können entlang der Ortsraumlinie Phasensprünge auftreten, sodass insbesondere nach der Subtraktion noch ein Phase-Unwrap beziehungsweise ein Auswickeln der Phase erfolgen kann. Hierbei können Phasensprünge zwischen benachbarten Referenzpunkten entlang der Ortsraumlinie erkannt werden, die typischerweise aus einem Phasenüberlauf der zyklischen Phase resultieren, und beispielsweise durch addieren beziehungsweise subtrahieren eines ganzzahligen vielfachen von 360° zu Phasendifferenzen für die Referenzpunkte jenseits des Phasensprunges in an sich bekannter Weise kompensiert werden.

Ein hieraus resultierender Offset der Phasendifferenz kann anschließend beispielsweise eliminiert werden, indem die Phasendifferenz am zentralen Referenzpunkt auf null gesetzt wird und die weiteren Phasendifferenzen entsprechend um den ursprünglichen Wert der Phasendifferenz für den zentralen Referenzpunkt reduziert werden.

Die ersten und zweiten Magnetresonanzdaten können jeweils mehrere Kanalteildaten umfassen, die über verschiedene Messkanäle erfasst, beispielsweise über verschiedene Messspulen empfangen, werden. Prinzipiell können die jeweiligen Kanalteildaten unmittelbar kombiniert werden, um die ersten und zweiten Magnetresonanzdaten bereitzustellen und wie obig erläutert zu verarbeiten.

Es kann jedoch vorteilhaften sein, die Kanalteildaten zunächst separat voneinander zu verarbeiten. Beispielsweise können die Phasendifferenzen und/oder die Korrekturparameter und/oder die Metakorrekturparameter zunächst separat für die verschiedenen Kanäle ermittelt werden und anschließend kann beispielsweise eine Mittelung beziehungsweise eine gewichtete Summe berechnet werden, um für die jeweilige Größe ein jeweiliges Gesamtergebnis bereitzustellen. Hierbei ist es auch möglich, die Daten aus bestimmten Kanälen zu verwerfen, beispielsweise wenn für diese ein geringes Signal-zu-Rauschverhältnis ermittelt wird und/oder wenn die für einen Kanal resultierenden Größen nicht konsistent mit für weitere Kanäle ermittelten Größen sind. Dies kann beispielsweise auf einen Defekt des Kanals hinweisen.

Neben dem computerimplementiertes Verfahren zur Ermittlung einer Korrekturinformation betrifft die Erfindung ein computerimplementiertes Verfahren zur Rekonstruktion von Bilddaten einer Magnetresonanzbildgebung in einem Untersuchungsvolumen, wobei Signalkurven verarbeitet werden, die jeweils den Verlauf einer k-Raum-Amplitude und/oder einer k-Raum-Phase des Magnetresonanzsignals entlang einer k-Raum-Linie in einem einer jeweiligen Messschicht zugeordneten zweidimensionalen k-Raum beschreiben, wobei das Verfahren die folgenden Schritte umfasst:
- Fouriertransformation der jeweiligen Signalkurve zur Bereitstellung einer jeweiligen Ortsraumkurve,
- lokales strecken und/oder stauchen der jeweiligen Ortsraumkurve, um eine jeweilige korrigierte Ortsraumkurve bereitzustellen, wobei der lokale Grad der Stauchung und/oder Streckung in Abhängigkeit einer ortsabhängigen Korrekturinformation vorgegeben wird, die Feldinhomogenitäten des Magnetfeldes in dem Untersuchungsvolumen betrifft, die durch das Beaufschlagen des Untersuchungsvolumens mit einem Magnetfeldgradienten resultieren,
- Fouriertransformation der jeweiligen korrigierten Ortsraumkurve zur Bereitstellung einer jeweiligen korrigierten Signalkurve, und
- Rekonstruktion der Bilddaten auf Basis der korrigierten Signalkurven.

Wie bereits obig zur Ermittlung der Korrekturinformation erläutert wurde, führen Feldinhomogenitäten im Messvolumen zu einer Änderung der Phase des in dem jeweiligen Bereich des Untersuchungsvolumens abgestrahlten Magnetresonanzsignals.

Wird eine Phasenkodierung in die Gradientenrichtung verwendet, so führen die Feldinhomogenitäten somit zu einer lokalen Verzerrung der Ortsraumkurve, also der Fouriertransformation der Signalkurve des empfangenen Messesignals. Da die Feldinhomogenitäten des Magnetfeldes in dem Untersuchungsvolumen jedoch durch Verwendung der Korrekturinformation zumindest näherungsweise bekannt sind beziehungsweise auf Basis dieser Korrekturinformation zumindest näherungsweise ermittelt werden können, kann die aus dieser Verzerrung resultierende Verfälschung der Signalkurve zumindest weitgehend kompensiert werden und somit kann die Qualität des Rekonstruktionsergebnisses deutlich verbessert werden.

Die Feldinhomogenität des Magnetfeldgradienten kann insbesondere durch die obig erläuterten Phasendifferenzen für die Referenzpunkte oder durch aus diesen Phasendifferenzen ermittelte Größen, also insbesondere durch den wenigstens einen obig erläuterten Korrekturparameter beziehungsweise Metakorrekturparameter für die jeweilige Gradientenrichtung beschrieben sein. Die Korrekturinformation kann somit diese Phasendifferenzen, Korrekturparameter und/oder Metakorrekturparameter umfassen oder, beispielsweise durch Vorgabe von Parametern für eine vorgegebene Funktion, beschreiben.

Vorzugsweise wird als die Korrekturinformation eine Korrekturinformation verwendet, die durch das erfindungsgemäße computerimplementierte Verfahren zur Ermittlung einer Korrekturinformation ermittelt ist.

Da die Signalkurven der einzelnen k-Raum-Linien separat voneinander Fouriertransformiert und korrigiert werden, ordnet die Ortsraumkurve jeweils Koordinaten in einem eindimensionalen Ortsraum das Ergebnis der Fouriertransformation, also insbesondere eine Ortsraum-Amplitude und/oder -Phase beziehungsweise Quadraturkomponenten des Magnetresonanzsignals zu. Eine Richtung, in die sich die jeweilige k-Raum-Linie erstreckt, kann bei der Korrektur berücksichtigt werden, indem zur Korrektur der jeweiligen Signalkurve beziehungsweise Ortsraumkurve Teilinformationen der Korrekturinformation beziehungsweise aus den Korrekturinformationen ermittelte Korrekturgrößen genutzt werden, die der Gradientenrichtung, die bei der Erfassung dieser Signalkurve genutzt wurde, beziehungsweise der Richtung der k-Raum-Linie zugeordnet sind.

Die k-Raum-Linie verläuft bevorzugt geradlinig und umfasst insbesondere das k-Raum-Zentrum. In diesem Fall kann das Untersuchungsvolumen während der Erfassung der Signalkurve insbesondere mit einem zumindest näherungsweise konstanten Magnetfeldgradient beaufschlagt sein, sodass eine Phasenkodierung in die Linienrichtung erfolgt.

Insbesondere basieren die Signalkurven auf einer Radialsequenz mit Phasenkodierung in Radialrichtung. Die während der Erfassung verschiedener Signalkurven für verschiedene zueinander gewinkelte stehende k-Raum-Linien geschalteten Magnetfeldgradienten können insbesondere betragsgleich sein und sich nur bezüglich ihrer Gradientenrichtung voneinander unterscheiden. Dies ist insbesondere vorteilhaft, wenn Feldinhomogenitäten korrigiert werden sollen, deren Stärke nicht linear von der Stärke der geschalteten Magnetfeldgradienten abhängt. Wird beispielsweise die obig erläuterte Ermittlung der Korrekturinformation genutzt, werden in diesem Fall bereits sehr gute Korrekturergebnisse erreicht, wenn Phasendifferenzen für zwei gewinkelt zu einander stehende Gradientenrichtung erfasst werden, wobei hierbei vorzugsweise zumindest näherungsweise die gleiche Gradientenfeldstärke genutzt wird, wie sie im Rahmen der Erfassung der Signalkurven verwendet wird.

Die Erfassung der Signalkurven kann als Teil des Verfahrens durchgeführt werden oder auch bereits vor Beginn des Verfahrens abgeschlossen sein.

Die Ermittlung der Korrekturinformation kann ein Teil des computerimplementierten Verfahrens zur Rekonstruktion der Bilddaten der Magnetresonanzbildgebung sein oder bereits vor Beginn des Verfahrens abgeschlossen sein. Besonders bevorzugt können die zur Ermittlung der Korrekturinformation verwendeten jeweiligen ersten und zweiten Magnetresonanzdaten im Rahmen der Magnetresonanzbildgebung beziehungsweise unmittelbar vor oder nach dieser oder zumindest durch die gleiche Bildgebungseinrichtung ohne Verlagerung des Untersuchungsobjekts erfasst werden. Hierdurch kann einerseits sichergestellt werden, dass für Bereiche des Messvolumens, in denen das Untersuchungsobjekt abgebildet wird, im Rahmen der Ermittlung der Korrekturinformation hinreichende Signalamplituden vorliegen. Zudem können hierdurch potentiell auch Feldinhomogenitäten erkannt und korrigiert werden, die aus der Wechselwirkung des Untersuchungsobjekts mit der Bildgebungseinrichtung resultieren.

Die Korrekturinformation kann erste Korrekturgrößen für eine erste k-Raum-Richtung und zweite Korrekturgrößen für eine gewinkelt zu der ersten k-Raum-Richtung stehende zweite k-Raum-Richtung vorgeben, wobei der lokale Grad der Stauchung und/oder Streckung, der im Rahmen der Ermittlung der korrigierten Signalkurve für wenigstens eine der k-Raum-Linien, die gewinkelt zu der ersten und zweiten k-Raum-Richtung verläuft, genutzt wird, in Abhängigkeit von interpolierten Korrekturgrößen ermittelt wird, die jeweils als gewichtete Summe einer der ersten und einer der zweiten Korrekturgrößen ermittelt werden.

Insbesondere kann die jeweilige k-Raum-Linie mit der ersten k-Raum-Richtung einen Offsetwinkel einschließen und die Gewichtung der jeweiligen ersten und zweiten Korrekturgröße in der gewichteten Summe kann von dem Offsetwinkel abhängen. Insbesondere kann die jeweilige erste Korrekturgröße mit dem Quadrat des Kosinus des Offsetwinkels und die jeweilige zweite Korrekturgröße mit dem Quadrat des Sinus des Offsetwinkels skaliert werden.

Die in der gewichteten Summe addierte erste und zweite Korrekturgröße könne insbesondere jeweils abgesehen von der voneinander unterschiedlichen Gradientenrichtung, die im Rahmen der Ermittlung genutzt wurde, auf gleiche Weise ermittelt sein. Handelt es sich bei den Korrekturgröße beispielsweise um Phasendifferenzen, so können die Phasendifferenzen für die jeweils gleiche Position entlang der jeweiligen Linie im Ortsraum gewichtet addiert werden. Handelt es sich bei den Korrekturgröße hingegen beispielsweise um Korrekturparameter oder Metakorrekturparameter, die Koeffizienten eines Polynoms sind, so können die Koeffizienten für die gleiche Potenz der Variable gewichtet addiert werden.

Bevorzugt sind die Korrekturgrößen für zumindest näherungsweise orthogonale k-Raum-Richtungen vorgegeben. Die k-Raum-Richtungen können den Gradientenrichtungen entsprechen, für die, wie oben erläutert, Phasendifferenzen ermittelt werden. Die k-Raum-Richtungen, für die Korrekturgrößen durch die Korrekturinformation vorgegeben werden, können durch die Geometrie der Messeinrichtung vorgegeben sein, also beispielsweise den Richtungen der Gradientenbeaufschlagung durch ein jeweiliges Gradientenspulenpaar entsprechen.

Die Ermittlung der korrigierten Signalkurve für die jeweilige k-Raum-Linie, die in die ersten beziehungsweise zweiten k-Raum-Richtung verläuft, kann unmittelbar in Abhängigkeit der ersten beziehungsweise zweiten Korrekturgrößen erfolgen.

Durch das beschriebene Vorgehen kann die Korrekturinformation mit geringem Aufwand beziehungsweise sehr schnell ermittelt werden, sodass es beispielsweise möglich ist, die Ermittlung der Korrekturinformation unmittelbar vor oder nach Erfassung der Signalkurven zur Bildgebung durchzuführen, ohne dass dies zu einer merklichen Verlängerung der erforderlichen Messzeit führt.

Prinzipiell ist es auch möglich, dass durch die Korrekturinformation jeweilige Korrekturgrößen für mehr als zwei k-Raum-Richtungen vorgegeben werden. In diesem Fall kann eine Interpolation für k-Raum-Linien, für die die Korrekturgrößen nicht direkt vorgegeben sind, durch Interpolation zwischen den jeweils nächstliegenden k-Raum-Richtungen erfolgen.

Die Vorgabe der Korrekturgrößen durch die Korrekturinforation kann unmittelbar oder auch implizit, beispielsweise durch Vorgabe von Parametern einer Ermittlungsfunktion, erfolgen.

In dem erfindungsgemäße Verfahren können Bilddaten für mehrere Messschichten rekonstruiert werden, wobei Messdaten verarbeitet werden, bei deren Erfassung zusätzlich eine Phasenkodierung in eine Schichtselektionsrichtung genutzt wird, wodurch die Messdaten in Schichtselektionsrichtung im Frequenzraum vorliegen, wonach durch eine Fouriertransformation der jeweiligen Messdaten in Schichtselektionsrichtung für unterschiedliche Positionen in Schichtselektionsrichtung und somit für unterschiedliche Messschichten die Signalkurven bereitgestellt werden.

Somit kann bei einer dreidimensionalen Messdatenerfassung, die eine Phasenkodierung in Schichtselektionsrichtung nutzt, vorzugsweise zunächst eine Transformation der Messerdaten in separate zweidimensionale k-Räume erfolgen, in denen die Korrektur jeweils separat erfolgen kann. Im einfachsten Fall kann hierbei davon ausgegangen werden, dass durch eine Gradientenbeaufschlagung verursachte Feldinhomogenitäten in allen Schichten gleich sind, womit alle Schichten auf gleiche Weise, beispielsweise unter Verwendung der gleichen Korrekturgrößen, korrigiert werden können.

Wie bereits obige detailliert erläutert wurde, kann im Rahmen der Ermittlung der Korrekturinformation jedoch auch erkannt werden, wenn aus der Gradientenbeauflschlagung in unterschiedlichen Schichten unterschiedliche Feldinhomogenitäten resultieren, insbesondere indem die Phasendifferenzen separat für die verschiedenen Messschichten ermittelt werden. In diesem Fall kann die Korrekturinformation für die verschiedenen Messschichten separate Sätze von Korrekturgrößen vorgegeben beziehungsweise auf Basis der Korrekturinformation, beispielsweise auf Basis der obige erläuterten Metakorrekturparameter, können entsprechende Korrekturgrößen für die einzelnen Schichten ermittelt werden.

Neben den erfindungsgemäßen Verfahren betrifft die Erfindung eine Verarbeitungsvorrichtung, die zur Durchführung des erfindungsgemäßen computerimplementierten Verfahrens zur Ermittlung einer Korrekturinformation und/oder des erfindungsgemäßen computerimplementierten Verfahrens zur Rekonstruktion von Bilddaten einer Magnetresonanzbildgebung in einem Untersuchungsvolumen eingerichtet ist.

Zudem betrifft die Erfindung ein Computerprogramm, umfassend Programmanweisungen, die dazu ausgebildet sind, das erfindungsgemäße computerimplementierte Verfahren zur Ermittlung einer Korrekturinformation und/oder das erfindungsgemäße computerimplementierte Verfahren zur Rekonstruktion von Bilddaten einer Magnetresonanzbildgebung in einem Untersuchungsvolumen zu implementieren, wenn sie auf einer Datenverarbeitungseinrichtung ausgeführt werden.

Zudem betrifft die Erfindung einen Datenträger, der das erfindungsgemäße Computerprogramm umfasst.

Weitere Vorteile und Einzelheiten der Erfindung ergeben sich aus den folgenden Ausführungsbeispielen sowie den zugehörigen Zeichnungen. Hierbei zeigen schematisch:
- Fig. 1: ein Ausführungsbeispiel einer erfindungsgemäßen Verarbeitungsvorrichtung, durch die ein Ausführungsbeispiel eines erfindungsgemäßen Verfahrens zur Ermittlung einer Korrekturinformation und zur Rekonstruktion von Bilddaten einer Magnetresonanzbildgebung durchgeführt wird,
- Fig. 2: ein Ablaufdiagramm für das in Fig. 1 durchgeführte Verfahren,
- Fig. 3: eine Illustration der Abtastung von Messpunkten in einem k-Raum,
- Fig. 4: die Anordnung von Referenzpunkten in einem Ortsraum, für die auf Basis der in Fig. 3 gezeigten Messpunkte Amplituden und Phasen des Magnetresonanzsignals am jeweiligen Referenzpunkt ermittelbar sind,
- Fig. 5: eine Ortsraumkurve, die den Verlauf der Amplitude des Magnetresonanzsignals entlang einer der Fig. 4 gezeigten Ortsraumlinien zeigt,
- Fig. 6: im Rahmen des in Fig. 2 gezeigten Verfahrens ermittelte Phasendifferenzen, und
- Fig. 7: eine Illustration zur Ermittlung von Metakorrekturparameter im Rahmen des in Fig. 2 gezeigten Verfahrens.

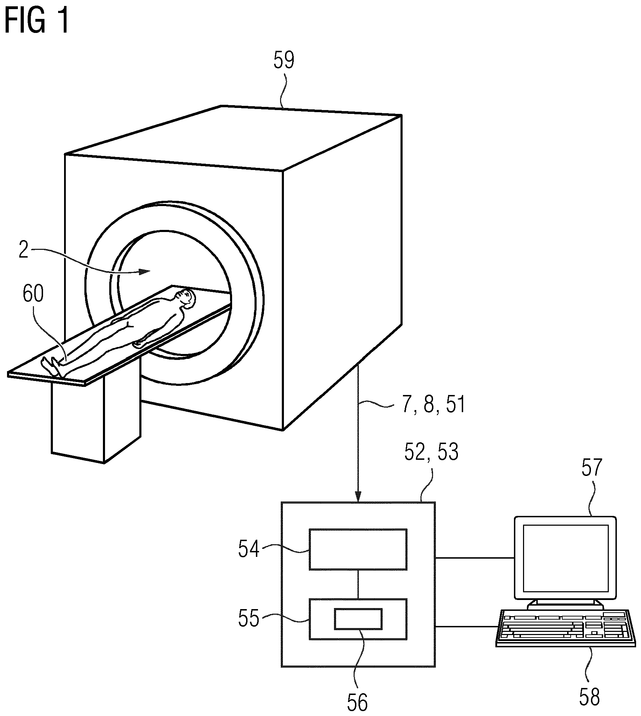

Fig. 1 zeigt eine Verarbeitungsvorrichtung 52, die zur Rekonstruktion von Bilddaten einer Magnetresonanzbildgebung dient. Im Beispiel werden die hierzu verarbeiteten Messdaten 51 beziehungsweise Magnetresonanzdaten 7,8, auf deren Basis eine Korrektur der Messdaten 51 im Rahmen der Rekonstruktion erfolgt, unmittelbar von eine Bildgebungseinrichtung 59 bereitgestellt, in deren Untersuchungsvolumen 2 ein Patient beziehungsweise ein Untersuchungsobjekt 60 aufgenommen ist.

Wie später noch im Detail erläutert werden wird, sollen durch die Korrektur der Messdaten 51 Artefakte beziehungsweise Abbildungsfehler korrigiert werden, die daraus resultieren, dass bei einer Beaufschlagung des Untersuchungsvolumens 2 mit einem Magnetfeldgradienten, beispielsweise aufgrund von Wirbelströmen, ungewünschte Feldinhomogenitäten auftreten können, die die Bildgebung stören.

Daher sollen, wie später noch genauer erläutert wird, bestimmte Magnetresonanzdaten 7,8 erfasst werden, auf deren Basis eine Korrekturinformation bestimmt wird, auf deren Basis die aus solchen Feldinhomogenitäten resultierenden Störungen der Abbildung eliminiert beziehungsweise zumindest weitgehend unterdrückt werden können. Die Bildgebung kann im Beispiel über ein Eingabemittel 58 gesteuert werden und Messergebnisse beziehungsweise rekonstruierte Bilddaten können über eine Anzeigeeinrichtung 57 ausgegeben werden.

Die Magnetresonanzdaten 7,8 und die Messdaten 51 können im Rahmen eines gemeinsamen Erfassungsprozesses erfasst werden. Alternativ wäre es auch möglich, die Magnetresonanzdaten 7,8 und/oder die Messdaten 51 beispielsweise aus einer Datenbank auszulesen beziehungsweise ausschließlich eine Korrekturinformation zur späteren Korrektur von Messerdaten zur ermitteln oder ausschließlich die Messdaten 51 zu erfassen und eine bereits vorangehend ermittelte Korrekturinformation zu deren Korrektur zu nutzen.

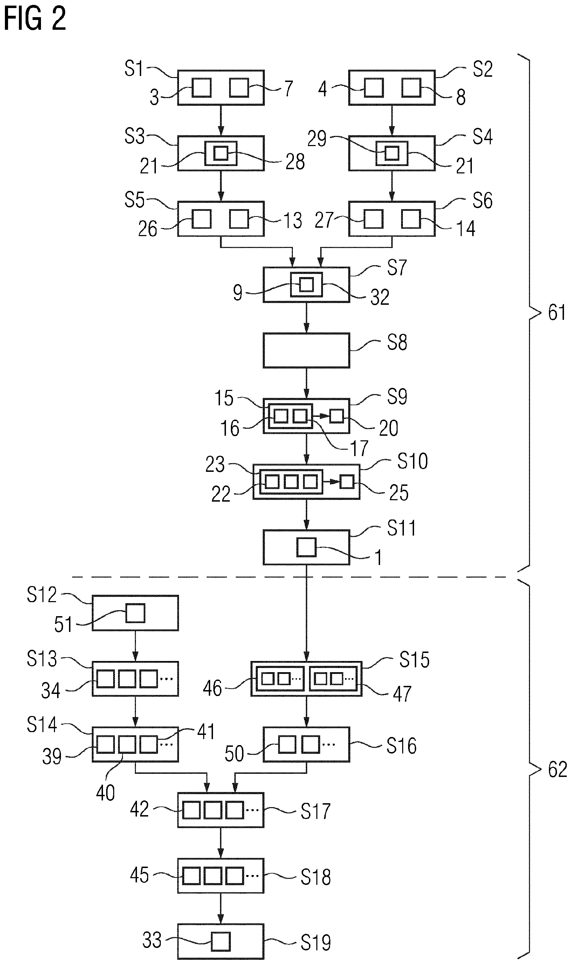

Fig. 2 zeigt ein Ablaufdiagramm für eine beispielhafte Ausgestaltung des durch die Verarbeitungsvorrichtung 52 durchgeführten Verfahrens zur Ermittlung einer Korrekturinformation und zur Rekonstruktion von Bilddaten einer Magnetresonanzbildgebung. Das in Fig. 2 illustrierte Verfahren umfasste ein erstes Teilverfahren 61, in dem die Korrekturinformation 1 ermittelt wird, und ein zweites Teilverfahren 62, in dem die Korrekturinformation 1 verwendet wird, um Messdaten 51 der Magnetresonanzbildgebung im Rahmen der Rekonstruktion der Bilddaten 33 zu korrigieren.

Die Teilverfahren 61, 62 können prinzipiell auch zeitliche beabstandet voneinander durchgeführt werden. Kann beispielsweise davon ausgegangen werden, dass der Einfluss des Untersuchungsobjekts 60 auf Feldinhomogenitäten, die aus der Applikation von Feldgradienten 7, 8 im Untersuchungsvolumen 2 resultieren, näherungsweise vernachlässigt werden kann, so kann die Korrekturinformation 1 beispielsweise für eine Vielzahl von Bildgebungen an verschiedenen Untersuchungsobjekt 60 gemeinsam ermittelt werden, beispielsweise bei einer Herstellung oder Kalibrierung der Bildgebungseinrichtung 59.

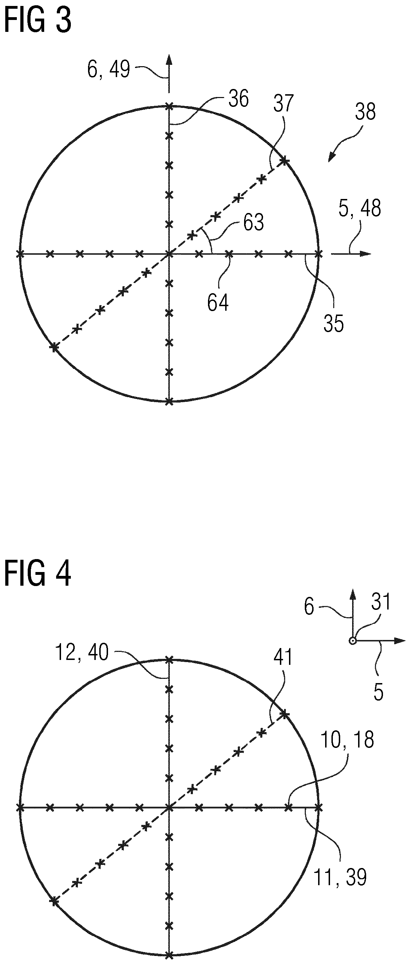

Da es jedoch typischerweise ausreichend ist, im Rahmen des Teilverfahrens 61 Magnetresonanzdaten 7, 8 für nur 2 Gradientenrichtungen 5, 6, die schematisch in Fig. 3 und 4 dargestellt sind, zu erfassen, ist die erforderliche Messzeit für das erste Teilverfahren 61 verglichen mit der Messzeit für die Bildgebung selbst typischerweise vernachlässigbar, sodass das erste Teilverfahren 61 vorzugsweise ergänzend zu jeder Erfassung von Messdaten 51 zur Bildgebung oder zumindest einmal im Rahmen eine Bildgebungsserie am gleichen Untersuchungsobjekt 60 durchgeführt werden kann.

Fig. 2 zeigt eine vorteilhafte Ausgestaltung des Gesamtverfahrens. Wie bereits im allgemeinen Teil der Beschreibung dargestellt wurde, ist es zur Umsetzung des Erfindungsgegenstandes nicht erforderlich, dass alle gezeigten beziehungsweise erläuterten Verfahrensschritte durchgeführt werden beziehungsweise alle erläuterten Merkmale umgesetzt werden. Einige der erläuterten Ausgestaltungen können auch durch alternative Ausgestaltungen ersetzt werden. Während in der folgenden Erläuterung auf einzelne beispielhafte Modifikationsmöglichkeiten des erläuterten Verfahrens hingewiesen wird, sind darüber hinaus auch andere Abwandlungen möglich, insbesondere Modifikationen, die bereits im allgemeinen Teil der Beschreibung diskutiert wurden.

Das Teilverfahren 61 ist ein Verfahren zur Ermittlung einer Korrekturinformation 1. Die Korrekturinformation 1 dient zur Korrektur von Abbildungsfehlern einer Magnetresonanzbildgebung und betrifft Feldinhomogenitäten des Magnetfeldes in dem Untersuchungsvolumen 2, die durch das Beaufschlagen des Untersuchungsvolumens 2 mit einem Magnetfeldgradienten 3, 4 in wenigstens eine Gradientenrichtung 5, 6 resultieren.

Im Beispiel werden hierbei für die beiden Gradientenrichtungen 7, 8 Korrekturinformationen ermittelt. Da die für die jeweilige Gradientenrichtung 5, 6 durchgeführten Verfahrensschritte S1 bis S10 jedoch abgesehen von der Richtung der Feldbeaufschlagung identisch sind, werden diese Schritte nur für die Gradientenrichtung 5 beschriebenen und sind aus Übersichtlichkeitsgründen in Fig. 2 auch nur für diese Gradientenrichtung 5 dargestellt. Für die Gradientenrichtung 6 werden entsprechend die gleichen Schritte durchgeführt.

In Schritt S1 werden erste Magnetresonanzdaten 7 erfasst, während das Untersuchungsvolumen 2 mit dem Magnetfeldgradienten 3 in die Gradientenrichtung 5 beaufschlagt ist. Hierdurch erfolgt eine Phasenkodierung in die Gradientenrichtung 5.

Wird zunächst vereinfachend von einer Erfassung der Magnetresonanzdaten 7 für eine einzelne angeregte Messschicht ausgegangen, so würde durch den Magnetfeldgradient eine Abtastung des in Fig. 3 schematisch dargestellten zweidimensionalen k-Raums 38 in die Gradientenrichtung 5 und somit entlang der k-Raum-Linie 35 erfolgen. Nacheinander werden somit Messwerte für die k-Raum-Punkte 64 entlang der k-Raum-Linie 35 erfasst. Aus Übersichtlichkeitsgründen sind hierbei nur zehn k-Raum-Punkte 64 dargestellt, wobei typischerweise eine dichtere Datenerfassung erfolgt.

Im Rahmen der Messdatenerfassung werden Quadraturanteile des Empfangssignals erfasst, sodass für die unterschiedlichen k-Raum-Punkte auf Basis dieser Quadraturkomponenten die k-Raum-Amplituden und k-Raum-Phasen des Magnetresonanzsignals bekannt sind.

In Schritt S2 werden zweite Magnetresonanzdaten 7 erfasst, während das Untersuchungsvolumen 2 mit dem Magnetfeldgradient 4 entgegen der Gradientenrichtung 5 beaufschlagt ist. Abgesehen von dem unterschiedlichen Gradientenvorzeichen entspricht Schritt S2 dem vorangehend erläuterten Schritt S1.

Um zusätzliche Informationen bezüglich der Feldinhomogenität in die Schichtselektionsrichtung 31 zu erhalten, die insbesondere senkrecht auf der in Fig. 3 gezeigten k-Raum-Ebene beziehungsweise der in Fig. 4 gezeigten Ortsraumebene steht, erfolgt im Beispiel in den Schritten S1 und S2 bei der Erfassung der jeweiligen Magnetresonanzdaten 7, 8 zusätzlich eine Phasenkodierung in die Schichtselektionsrichtung 31. Hierdurch liegen die ersten und zweiten Magnetresonanzdaten 7, 8 zunächst in Schichtselektionsrichtung 31 im frequenzcodiert vor.

In Schritt S3 und S4 erfolgt dann jeweils eine Fouriertransformation der jeweiligen ersten beziehungsweise zweiten Messdaten 7, 8 in die Schichtselektionsrichtung 31. Hierdurch werden für unterschiedliche Positionen 24 in Schichtselektionsrichtung 31 und somit für unterschiedliche Messschichten 21 jeweils von den ersten Messdaten 7 abhängige erste Teilmessdaten 28 und von den zweiten Messdaten 8 abhängige zweite Teilmessdaten 29 für jede der Messschichten 21 generiert. Die Teilmessdaten 28 und 29 betreffenden somit k-Raum-Amplituden und k-Raum-Phasen des Magnetresonanzsignals entlang der k-Raum-Linien 35, 36, die in der jeweiligen Gradientenrichtung 5, 6 frequenzkodiert sind. Die nachfolgenden Schritte S5 bis S7 können dann für die einzelnen Schichten 21 separater durchgeführt werden.

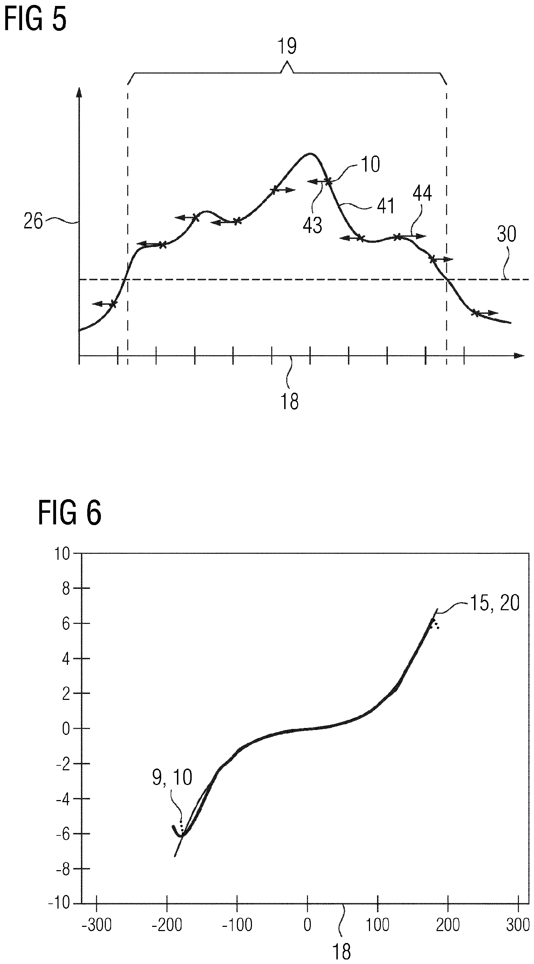

Durch eine Fouriertransformation der Teilmessdaten 28 können somit in Schritt S5 für Referenzpunkte 10 entlang einer jeweiligen Ortsraumlinie 11, 12 im Ortsraum, die parallel zur jeweiligen Gradientenrichtung 5, 6 verläuft, jeweils eine Phase 13 und eine Amplitude 26 des Magnetresonanzsignals für die jeweilige Position im Ortsraum ermittelt werden. Aus Übersichtlichkeitsgründen werden im Beispiel nur 10 Referenzpunkte 10 genutzt. In realen Anwendungen werden vorzugsweise deutlich mehr Referenzpunkte, beispielsweise über hundert Referenzpunkte, genutzt. Ein Beispiel für eine Ortsraumkurve 41, die für die Amplitude 26 entlang eine der Ortsraumlinien 11,12 resultieren kann, ist in Fig. 5 dargestellt.

Im Schritt S6 werden auf gleiche Weise für die Referenzpunkte 10 entlang der jeweiligen Ortsraumlinie 11, 12 im Ortsraum, jeweils eine Phase 14 und eine Amplitude 27 des Magnetresonanzsignals an der jeweiligen Position im Ortsraum ermittelt.

Werden die ersten und zweiten Messdaten 7, 8 innerhalb eines hinreichend kurzen Zeitfensters aufgenommen, sodass Bewegungen des Untersuchungsobjekts 60 im Untersuchungsvolumen 2 zumindest näherungsweise vernachlässigt werden können, so wäre zunächst anzunehmen, dass die beiden für den jeweiligen Referenzpunkte 10 ermittelten Amplituden 26, 27 und Phasen 13, 14, abgesehen von einem Rauschbeitrag, jeweils zueinander gleich sind. Wie jedoch bereits im allgemeinen Teil detailliert diskutiert wurde, führt eine Feldbeaufschlagung des Untersuchungsvolumens 2 in die jeweilige Gradientenrichtung 5, 6 und entgegen der jeweiligen Gradientenrichtung typischerweise zu Feldinhomogenitäten, beispielsweise aufgrund von induzierten Wirbelströmen, wobei für die beiden unterschiedlichen Richtungen der Abtastung des k-Raums für eine jeweilige Position im Untersuchungsvolumen 2 zumindest näherungsweise gleiche Beträge der lokalen Feldinhomogenität und unterschiedliche Polaritäten der lokalen Feldinhomogenität resultieren. Die ermittelten Phasen 13, 14 können somit genutzt werden, um die lokale Feldinhomogenität am jeweiligen Referenzpunkt beziehungsweise ihren Einfluss auf die Bildgebung zu quantifizieren.

Hierzu wird in Schritt S7 für den jeweiligen Referenzpunkte 10 zunächst eine Phasendifferenzen 9 ermittelt. Da die Phase des Magnetresonanzsignals eine zyklische Größe ist, werden hierbei Phasensprünge durch einen sogenannten Phase-Unwrap erkannt und korrigiert. Die Phasendifferenzen 9 für die jeweilige Ortsraumlinie werden somit durch einen Phasenkorrekturalgorithmus 32 ermittelt, der dazu eingerichtet ist, durch Analyse des Verlaufs der Differenz zwischen der ermittelten ersten und zweiten Phase 13, 14 entlang der jeweiligen Ortsraumlinie 11, 12 Phasensprünge aufgrund eines Phasenüberlaufs zu erkennen und zu korrigieren.

Entsprechende Phasenkorrekturalgorithmen 32 werden im Rahmen der Magnetresonanzbildgebung bereits für vielfältige Zwecke genutzt und soll daher nicht detailliert erläutert werden. Ein durch den Phasenkorrekturalgorithmus 32 verursachte Offset kann korrigiert werden, indem das Ergebnis des Phasenkorrekturalgorithmus 32 für alle Referenzpunkte 10 um die nach Anwendung des Phasenkorrekturalgorithmus 32 für den Referenzpunkte 10, der mittig auf der jeweiligen Ortsraumlinie 11, 12 liegt, ermittelte Phasendifferenz reduziert wird.

Fig. 6 zeigt ein Beispiel, in dem die Phasendifferenzen 9 für eine Vielzahl von Referenzpunkten 10 beziehungsweise Positionen 18 entlang einer der Ortsraumlinie 11, 12 dargestellt sind. Um den Verlauf der Phasendifferenz 10 entlang der Ortsraumlinie 11, 12 besser darzustellen, werden in diesem Beispiel deutlich mehr Referenzpunkte 10 genutzt, als in Fig. 4 und 5 dargestellt sind.

Die resultierende Phasendifferenz entspricht zumindest näherungsweise dem Doppelten der Phasendifferenz, die am jeweiligen Referenzpunkte 10 aufgrund des jeweils geschalteten Magnetfeldgradienten 3, 4 resultiert, da, wie obig erläutert, eine Feldbeaufschlagung in entgegengesetzte Richtungen zu einem entgegengesetzten Vorzeichen der resultierten Feldinhomogenität führt, womit sich Beträge der resultierenden Phasenfehler bei der Subtraktion der Phasen 13, 14 addieren.

Wie bereits im allgemeinen Teil diskutiert, können die Phasendifferenzen für die einzelnen Referenzpunkte 7 prinzipiell unmittelbar als Korrekturinformation 1 verwendet werden. Durch die im Folgenden erläuterten weiteren Schritte kann jedoch eine weitere Verbesserung der später noch erläuterten Korrektur erreicht werden.

In den Schritten S8 bis S10 werden Korrekturparameter 16, 17 und auf Basis von diesen Metakorrekturparameter 22 bestimmt, die durch eine Parametrisierung der Metakorrekturfunktion 23 beziehungsweise der Korrekturfunktion 15 den Verlauf der Phasendifferenzen 9 im Untersuchungsvolumen 2 und somit die Feldinhomogenitäten zumindest näherungsweise beschreiben. Eine solche Beschreibung ist insbesondere vorteilhaft, da hierdurch auch Phasendifferenzen 9 beziehungsweise Feldinhomogenitäten in Bereichen des Messvolumens 2 beschrieben werden können, in denen aufgrund einer sehr geringen Amplitude des Magnetresonanzsignals 2, beispielsweise weil sie außerhalb des Untersuchungsobjekts 60 liegen, die ermittelten Phasen 13, 14 starke rauschbehaftet sind und somit die zunächst ermittelten Phasendifferenzen voraussichtlich stark fehlerbehaftet ist.

Um dies zu erreichen werden in Schritt S8 zunächst eine Untergruppe der Messschichten 21 und eine Untergruppe 19 der Referenzpunkte 10 in diesen Schichten 21 gewählt, in beziehungsweise an denen das Magnetresonanzsignal eine hinreichende Amplitude 13 beziehungsweise 14 aufweist, um eine robuste Phasenermittlung zu ermöglichen.

Es kann näherungsweise davon ausgegangen werden, dass die Amplituden 13, 14 zueinander gleich sind und die Auswahl kann ausschließlich auf Basis einer dieser beiden Amplituden 13, 14 basieren. Aus Gründen der kompakten Darstellung erfolgt im Beispiel die Auswahl der Untergruppen der Referenzpunkte 10 und Schichten 21 ausschließlich in Abhängigkeit der Amplituden 13.

Alternativ kann eine solche Auswertung jedoch sowohl für die Amplitude 13 als auch für die Amplitude 14 erfolgen und es können ausschließlich Schichten 21 und Referenzpunkte 10 in die jeweilige Untergruppe aufgenommen werden, die auf Basis beider Amplituden 13, 14 gewählt würden. Alternativ wäre es beispielsweise auch möglich, die Auswertung auf Basis einer Summe oder eines Mittelwerts der Amplituden 13, 14 durchzuführen.

Zunächst soll eine Untergruppe der Schichten 21 gewählt werden, innerhalb der hinreichende Amplituden 13 auftreten. Hierzu werden im Beispiel für jede der Schichten 21 die Amplituden der in der jeweiligen Messschicht liegenden Referenzpunkte 10 addiert und diese Summe wird mit einem Grenzwert verglichen. Die Untergruppe der Schichten 21 umfasst im Beispiel ausschließlich jene Schichten 21, für die diese Summe einen vorgegebenen Grenzwert erreicht oder überschreitet. Hierdurch können insbesondere Schichten 21 unberücksichtigt bleiben, die außerhalb des Untersuchungsobjekts 60 liegen beziehungsweise in denen überwiegend Luft und/oder andere Materialien mit geringem Magnetresonanzsignal abgebildet werden.

Die Untergruppe 19 der Referenzpunkte 10 kann insbesondere ausschließlich aus den Referenzpunkten 10 ausgewählt werden, die innerhalb von Schichten 21 in der Untergruppe der Schichten 21 liegen. Zudem werden im Beispiel ausschließlich Referenzpunkte 10 in die Untergruppe 19 der Referenzpunkte 10 aufgenommen, für die die dortige Amplitude 13 einen Amplitudengrenzwert 30 überschreitet. Eine solche Auswahl ist beispielhaft in Fig. 5, die eine Ortsraumkurve 41 der Amplitude 26 zeigt, dargestellt.

Wird davon ausgegangen, dass ausschließlich ein einzelnes Untersuchungsobjekt 60 abgebildet wird, kann die Untergruppe 19 der Referenzpunkte 10 zudem nur Referenzpunkte 10 aufnehmen, die in einem zusammenhängenden Bereich der Messschicht 21 liegen, innerhalb dem die Amplitude 13 aller Referenzpunkte 10 den Amplitudengrenzwert 30 erreicht oder überschreitet.

Im Schritt S9 werden Korrekturparameter 16, 17 bestimmt, indem eine Korrekturfunktion 15 durch jeweils geeignete Wahl der Korrekturparameter 16, 17 an die Phasendifferenzen 9, die für die verschiedenen Referenzpunkte 10 beziehungsweise Positionen 18 entlang der jeweiligen Ortsraumlinie 11, 12 für die jeweilige Messschicht 21 ermittelt wurden, gefitted wird, wobei im Beispiel ausschließlich die Referenzpunkte 10, die Teil der Untergruppe 19 sind, berücksichtigt werden. Anders ausgedrückt wird ein Maß für die Abweichungen zwischen dem für den jeweiligen Referenzpunkt 10 durch die Korrekturfunktion 15 vorgegebenen Phasendifferenzwert 20 und der für diesen Referenzpunkt 10 ermittelten Phasendifferenz 9 für jene Referenzpunkte 10 entlang der jeweiligen Ortsraumlinie 11, 12, die Teil der Untergruppe 19 sind, durch Anpassung des Korrekturparameters 16, 17 minimiert.

Ein Beispiel für eine solche gefittete Korrekturfunktion 15 beziehungsweise die durch sie vorgegebenen Phasenwerte 20 ist in Fig. 6 dargestellt. Hierbei wird als Korrekturfunktion 15 im Beispiel ein Polynom dritten Grades in der Position 18 des jeweiligen Referenzpunktes 10 entlang der jeweiligen Ortsraumlinie 11, 12 als Variable verwendet, wobei die Korrekturparameter 16, 17 die Koeffizienten des Polynoms für die erste und dritte Potenz der Variable sind.

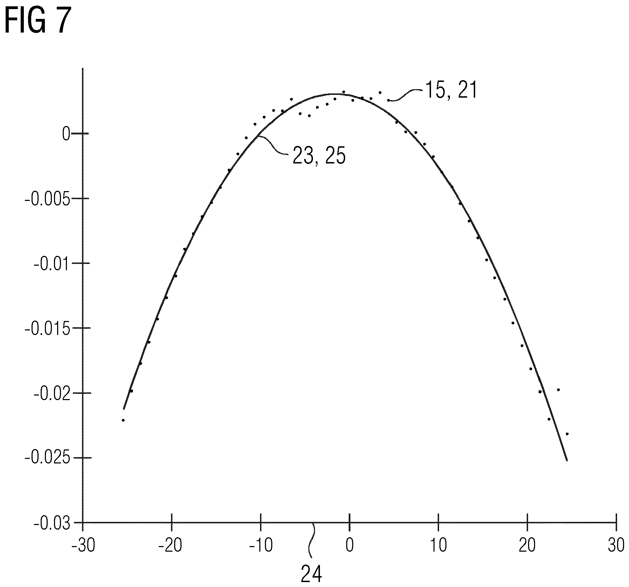

Wie schematisch in Fig. 7 dargestellt ist, werden anschließend in Schritt S10 Metakorrekturparameter 22 für ein jeweiliges Paar aus einem jeweiligen der Korrekturparameter 16, 17 und einer jeweiligen Gradientenrichtung 5, 6 bestimmt, indem ein eine durch die Metakorrekturparameter 22 parametrisierte Metakorrekturfunktion 23 an den Verlauf des jeweiligen Korrekturparameters 16, 17 für die jeweilige Gradientenrichtung 5, 6 in Schichtselektionsrichtung 24 angefittet wird. Hierbei werden im Beispiel ausschließlich die Messschichten in der Untergruppe der Messschichten berücksichtigt. Anders ausgedrückt wird für das jeweilige Paar jeweils ein Maß für die Abweichungen der für die verschiedenen Messschichten 21 durch die Metakorrekturfunktion 23 für dieses Paar vorgegebenen Korrekturwerte 25 von dem jeweiligen für das Paar und die jeweilige Messschicht 21 ermittelten Korrekturparameter 16, 17 für jene Messschichten 21, die Teil der Untergruppe der Messschichten sind, durch Anpassung der Metakorrekturparameter 22 minimiert.

Die Metakorrekturparameter 22 können dann als Korrekturinformation 1 bereitgestellt werden.

Wie bereits im allgemeinen Teil erläutert wurde, kann anstatt der Ermittlung der Metakorrekturparameter 22 auch eine Glättung der Korrekturparameter 16, 17 in Schichtselektionsrichtung 31, beispielsweise durch eine Filterung, erfolgen. In einer weiteren, im allgemeinen Teil genauer erläuterten Alternative wäre es möglich, statt den separaten Fitvorgängen in den Schritten S9 und S10 unmittelbar eine Korrekturfunktion, die von der Position des jeweiligen Referenzpunktes entlang der jeweiligen Ortsraumlinie 11, 12 und in Schichtselektionsrichtung 31 abhängt, an die ermittelten Phasendifferenzen in einer durch die jeweilige Ortsraumlinie 11, 12 und die Schichtselektionsrichtung 31 aufgespannten Ebene zu fitten.

Mit Schritt S12 beginnt das zweite Teilverfahren 62, dass ein Verfahren zur Rekonstruktion von Bilddaten 33 einer Magnetresonanzbildgebung in dem Untersuchungsvolumen 2 ist, in dem die Korrekturinformation 1 zur Korrektur von Abbildungsfehlern verwendet wird, die aus ungewünschten Feldinhomogenitäten des Magnetfeldes in dem Untersuchungsvolumen 2, beispielsweise aufgrund von Wirbelströmen, resultieren.

Hierbei werden in Schritt S12 zunächst Messdaten 51 erfasst, die im Beispiel durch eine Radialsequenz erfasst werden, bei der der k-Raum senkrecht zur Schichtselektionsrichtung 31, also in einer in Fig. 4 gezeigten k-Raum-Ebene, sternförmig abgetastet wird. Während der Erfassung der Messerdaten für eine jeweilige k-Raum-Richtung beziehungsweise k-Raum-Linie 35, 36, 37 ist somit ein Feldgradient in die jeweilige Gradientenrichtung 5, 6 geschaltet. Für die Gradientenrichtungen 5, 6 kann hierbei jeweils ein separates Gradientenspulenpaar vorgesehen sein und zur Abtastung von gewinkelte zu den k-Raum-Linien 35, 36 stehenden k-Raum-Linien 37 kann eine Überlagerung von Gradienten in die Gradientenrichtungen 5,6 erfolgen, um insgesamt einen gewinkelte zu den Gradientenrichtungen 5, 6 stehenden Gesamtgradienten bereitzustellen. Aus Übersichtlichkeitsgründen sind in Fig. 3 nur drei k-Raum-Linien 35, 36,37 eingezeichnet. Typischerweise wird jedoch eine Vielzahl von k-Raum-Linien abgetastet, um den k-Raum dicht abzutasten.

Bei deren Erfassung der Messdaten 51 wird im Beispiel zusätzlich eine Phasenkodierung in die Schichtselektionsrichtung 31 genutzt. Somit liegen die Messdaten zunächst in einem dreidimensionalen k-Raum beziehungsweise in Schichtselektionsrichtung 31 betrachtet im Frequenzraum vor.

Die einer jeweiligen k-Raum-Linie 35, 36, 37 zugeordneten Messerdaten werden anschließend in Schritt S13 Fouriertransformiert, um für einzelne in Schichtselektionsrichtung 31 aufeinanderfolgende Messschichten 21 eine jeweilige Signalkurve 34 für die jeweilige k-Raum-Linie 35, 36, 37 in der jeweiligen Messschicht 21 zu ermitteln, die jeweils den Verlauf einer k-Raum-Amplitude und/oder einer k-Raum-Phase des Magnetresonanzsignals entlang der k-Raum-Linie 35, 36, 37 beschreibt.

In Schritt S14 erfolgte dann eine Fouriertransformation der jeweiligen Signalkurve 34 zur Bereitstellung einer jeweiligen Ortsraumkurve 39, 40, 41. Die jeweilige Ortsraumkurve 39, 40, 41 beschreibt für die verschiedenen Positionen entlang der jeweiligen Ortsraumkurve 39, 40, 41 die Amplitude 26 beziehungsweise Phase 13 des Magnetresonanzsignals. Eine Ortsraumkurve 41 für die Amplitude 26 ist beispielhaft in Fig. 5 dargestellt.

Die verschiedenen Ortsraumkurve 35, 36, 37 sollen in Abhängigkeit der Korrekturinformation 1 verzerrt werden, um Abbildungsfehlern aufgrund von Feldinhomogenitäten zu kompensieren. Hierzu werden im Beispiel in Schritt S15 zunächst erste Korrekturgrößen 46 für die erste k-Raum-Richtung 48 und zweite Korrekturgrößen 47 für die zweite k-Raum-Richtung 49 für die jeweilige Messschicht 21 ermittelt. Da die Korrekturinformation 1 im Beispiel die Metakorrekturparameter 22 vorgibt, kann wie obig erläutert die Metakorrekturfunktion 23 genutzt werden, um für die jeweilige Messschicht 21, den jeweiligen Korrekturparameter 16, 17 und die jeweilige k-Raum-Richtung einen Korrekturparameterwert 25 vorzugeben.

In Schritt S16 werden zudem für k-Raum-Linien, die gewinkelt zu der ersten und zweiten k-Raum-Richtung 48, 49 verlaufen, beispielsweise für die k-Raum-Linie 37, interpolierte Korrekturgrößen 50 ermittelt. Hierzu kann eine Interpolation in Umfangsrichtung in Fig. 4 erfolgen. Insbesondere kann die interpolierte Korrekturgröße 50 für den jeweiligen Korrekturparameter 16, 17 als gewichtete Summe der Korrekturparameter für die Gradientenrichtungen 5, 6 auf dem gleichen Radius berechnet werden, wobei speziell die jeweilige Korrekturgröße für die Gradientenrichtung 5 mit dem Quadrat des Kosinus des Offsetwinkels 63 und die jeweilige Korrekturgröße für die Gradientenrichtung 6 mit dem Quadrat des Sinus des Offsetwinkels 63 skaliert werden kann.

Im Schritt S17 wird die jeweilige Ortsraumkurve 39, 40, 41 lokal gestreckt und/oder gestaucht, um eine jeweilige korrigierte Ortsraumkurve 42 bereitzustellen, wie dies in Fig. 5 schematisch durch Pfeile, die die Verschiebung definierter Referenzpunkte darstellen, illustriert ist. Der lokale Grad der Stauchung 43 und/oder Streckung 44 wird in Abhängigkeit der Korrekturinformation 1 bestimmt, nämlich im Beispiel konkret in Abhängigkeit der Korrekturgrößen 46, 47 beziehungsweise der interpolierten Korrekturgrößen 50 für die der jeweiligen Ortsraumkurve 39, 40, 41 zugeordneten k-Raum Linie 35, 36, 37.

Da im Beispiel die Korrekturgrößen 46, 47, 50 jeweils Werte für die Korrekturparameter 16, 17 der Korrekturfunktion 15 vorgeben, können für beliebige Referenzpunkte beziehungsweise Positionen 18 entlang der jeweiligen Ortsraumkurve 39, 40, 41 wie obig erläutert die Phasendifferenzwerte 20 bestimmt werden.

Da die Phasendifferenzwerte 20 zumindest näherungsweise die Phasendifferenzen 9, die im Rahmen der Ermittlung der Korrekturinformation bestimmt wurden und die mit dem Grad der Feldinhomogenität an der jeweilige Ortsraumposition korrelieren, beschreiben, kann aus dem ermittelten Phasendifferenzwert 20 für die jeweilige Position 18 für den jeweiligen Referenzpunkt 10 unmittelbar ermittelt werden, in welche Richtung und wie stark der jeweilige Referenzpunkt 10 zur Korrektur verschoben werden sollte. Ein entsprechender Zusammenhang kann beispielsweise durch eine Look-Up-Tabelle oder einen Skalierungsfaktoren vorgegeben sein. Durch geeignetes lokales Stauchen und/oder Strecken der Ortsraumkurve können diese Verschiebungen der Referenzpunkte 10 realisiert werden und somit kann die korrigierten Ortsraumkurve 25 bereitgestellt werden.

Im Schritt S18 kann dabb eine Fouriertransformation der jeweiligen korrigierten Ortsraumkurve 42 erfolgen, um eine jeweilige korrigierte Signalkurve 45 bereitzustellen, auf deren Basis dann in Schritt S19 in üblicher Weise eine Rekonstruktion der Bilddaten 33 erfolgen kann.

Die gezeigten Teilverfahren werden im Beispiel, wie in Fig. 1 dargestellt ist, durch eine Verarbeitungsvorrichtung 52 implementiert. Diese ist im Beispiel durch eine Datenverarbeitungseinrichtung 53 gebildet, die einen Prozessor 54 und einen Speicher 55 umfasst, in dem ein die Teilverfahren 61, 62 oder wenigstens eines der Teilverfahren implementierendes Computerprogramm 56 gespeichert ist.

Während die Verarbeitungsvorrichtung 52 im Beispiel als separate Komponente dargestellt ist, ist auch möglich, diese in die Bildgebungseinrichtung 59 oder einen Arbeitsplatzrechner, der zur Verarbeitung der Messdaten 51 dient, zu integrieren oder beispielsweise einen Server oder eine Cloudlösung als Verarbeitungsvorrichtung zu nutzen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Computerimplementiertes Verfahren zur Ermittlung einer Korrekturinformation (1), die zur Korrektur von Abbildungsfehlern einer Magnetresonanzbildgebung dient und die Feldinhomogenitäten des Magnetfeldes in einem Untersuchungsvolumen (2) betrifft, die durch das Beaufschlagen des Untersuchungsvolumens mit einem Magnetfeldgradienten (3, 4) in wenigstens eine Gradientenrichtung (5, 6) resultieren, umfassend die Schritte:
- Erfassen von jeweiligen ersten und zweiten Magnetresonanzdaten (7, 8) für wenigstens eine Gradientenrichtung (5, 6),
• wobei die ersten Magnetresonanzdaten (7) erfasst werden, während das Untersuchungsvolumen (2) mit dem Magnetfeldgradient (3) in die jeweilige Gradientenrichtung (5, 6) beaufschlagt wird, und
• wobei die zweiten Magnetresonanzdaten (8) erfasst werden, während das Untersuchungsvolumen (2) mit dem Magnetfeldgradient (4) entgegen der jeweiligen Gradientenrichtung (5, 6) beaufschlagt wird,
- Ermitteln einer jeweiligen Phasendifferenz (9) für mehrere Referenzpunkte (10) entlang einer jeweiligen Ortsraumlinie (11, 12) im Ortsraum, die in die jeweilige Gradientenrichtung (5, 6) verläuft, auf Basis einer Differenz zwischen
• einer ermittelten ersten Phase (13) des Magnetresonanzsignals am jeweiligen Referenzpunkt (10), die auf Basis der ersten Magnetresonanzdaten (7) ermittelte wird, und
• einer ermittelten zweiten Phase (14) des Magnetresonanzsignals am jeweiligen Referenzpunkt (10), die auf Basis der zweiten Magnetresonanzdaten (8) ermittelt wird,
- Bereitstellen der Phasendifferenzen (9) von zumindest einer Untergruppe der Referenzpunkte (10) als Korrekturinformation (1) oder Ermitteln der bereitgestellten Korrekturinformation (1) in Abhängigkeit der Phasendifferenzen (9) zumindest der Untergruppe (19) der Referenzpunkte (10).

2. Computerimplementiertes Verfahren nach Anspruch 1,
**dadurch gekennzeichnet, dass** eine vorgegebene Korrekturfunktion (15) den Referenzpunkten (10) entlang der jeweiligen Ortsraumlinie (11, 12) in Abhängigkeit wenigstens eines jeweiligen Korrekturparameters (16, 17) für die jeweilige Gradientenrichtung (11, 12) und der Position (18) des jeweiligen Referenzpunktes entlang der jeweiligen Ortsraumlinie (11, 12) einen Phasendifferenzwert (20) zuordnet,
wobei der jeweilige Korrekturparameter (16, 17) ermittelt wird, indem ein Maß für die Abweichungen zwischen dem für den jeweiligen Referenzpunkt (10) durch die Korrekturfunktion (15) vorgegebenen Phasendifferenzwert (20) und der für diesen Referenzpunkt (10) ermittelten Phasendifferenz (9) zumindest für jene Referenzpunkte (10) entlang der jeweiligen Ortsraumlinie (11, 12), die Teil der Untergruppe (19) sind, durch Anpassung des Korrekturparameters (16, 17) minimiert wird,
wobei die Korrekturinformation (1) den wenigstens einen jeweiligen Korrekturparameter (16, 17) für die jeweilige Gradientenrichtung (5, 6) umfasst oder von diesem abhängt.

3. Computerimplementiertes Verfahren nach Anspruch 2,
**dadurch gekennzeichnet, dass** als die Korrekturfunktion (17) ein Polynom wenigstens zweiten oder wenigstens dritten Grades in der Position (18) des jeweiligen Referenzpunktes (10) entlang der jeweiligen Ortsraumlinie (11, 12) als Variable verwendet wird, wobei wenigstens einer der Koeffizienten des Polynoms als Korrekturparameter (16, 17) verwendet wird.

4. Computerimplementiertes Verfahren nach Anspruch 2 oder 3, **dadurch gekennzeichnet, dass** die Phasendifferenzen (9) für Referenzpunkte (10) in mehreren in eine Schichtselektionsrichtung (31) aufeinanderfolgenden Messschichten (21) ermittelt werden,
wobei einem jeweiligen Paar aus Korrekturparameter (16, 17) und Gradientenrichtung (5, 6) jeweils wenigstens ein Metakorrekturparameter (22) zugeordnet ist, der als Teil der Korrekturinformation (1) bereitgestellt wird oder von dem die Korrekturinformation (1) abhängt,
wobei durch eine vorgegebene Metakorrekturfunktion (23) für das jeweilige Paar und die jeweilige Messschicht (21) in Abhängigkeit des jeweiligen dem Paar zugeordneten Metakorrekturparameters (22) und der Position (24) der jeweiligen Messschicht (21) in Schichtselektionsrichtung (31) ein Korrekturwert (25) vorgegeben wird,
wobei der jeweilige Metakorrekturparameter (22) ermittelt wird, indem der wenigstens eine jeweilige Korrekturparameter (16, 17) für die jeweilige Gradientenrichtung (5, 6) zunächst separat für jede Messschicht (21) zumindest einer Untergruppe der Messschichten (21) ermittelt wird,
wonach für das jeweilige Paar aus Korrekturparameter (16, 17) und Gradientenrichtung (5, 6) jeweils ein Maß für die Abweichungen der für die verschiedenen Messschichten (21) durch die Metakorrekturfunktion (23) für dieses Paar vorgegebenen Korrekturwerte (25) von dem jeweiligen für das Paar und die jeweilige Messschicht (21) ermittelten Korrekturparameter (16, 17) zumindest für jene Messschichten (21), die Teil der Untergruppe sind, durch Anpassung des jeweiligen Metakorrekturparameters (22) minimiert wird.

5. Computerimplementiertes Verfahren nach Anspruch 2 oder 3, **dadurch gekennzeichnet, dass** die Phasendifferenzen (9) für Referenzpunkte (10) in mehreren in eine Schichtselektionsrichtung (31) aufeinanderfolgenden Messschichten (21) ermittelt werden,
wobei der wenigstens eine jeweilige Korrekturparameter (16, 17) für die jeweilige Gradientenrichtung (5, 6) zunächst separat für jede Messschicht (21) zumindest einer Untergruppe der Messschichten (21) ermittelt wird, wodurch ein vorläufiger Parameterverlauf des jeweiligen Korrekturparameters (16, 17) in Schichtselektionsrichtung (31) vorgegeben wird,
wonach eine Glättungsfunktion diesen vorläufigen Parameterverlauf glättet, um einen jeweiligen geglätteten Parameterverlauf bereitzustellen, der als Teil der Korrekturinformation (1) bereitgestellt wird oder von dem die Korrekturinformation (1) abhängt.

6. Computerimplementiertes Verfahren nach Anspruch 1,
**dadurch gekennzeichnet, dass** die Phasendifferenzen (9) für Referenzpunkte (10) in mehreren in eine Schichtselektionsrichtung (31) aufeinanderfolgenden Messschichten (21) ermittelt werden,
wobei eine vorgegebene Korrekturfunktion (15) den Referenzpunkten (10) in einer jeweiligen Ebene, die durch die jeweilige Ortsraumlinie (11, 12) und die Schichtselektionsrichtung (31) aufgespannt ist, in Abhängigkeit wenigstens eines jeweiligen Korrekturparameters (16, 17) für die jeweilige Gradientenrichtung (5, 6) und der Position (18, 24) des jeweiligen Referenzpunktes (10) entlang der jeweiligen Ortsraumlinie (11, 12) und in Schichtselektionsrichtung (31) einen Phasendifferenzwert (20) zuordnet,
wobei der jeweilige Korrekturparameter (16, 17) ermittelt wird, indem ein Maß für die Abweichungen zwischen dem für den jeweiligen Referenzpunkt (10) durch die Korrekturfunktion vorgegebenen Phasendifferenzwert (20) und der für diesen Referenzpunkt (10) ermittelten Phasendifferenz (9) zumindest für jene Referenzpunkte (10) in der jeweiligen Ebene, die Teil der Untergruppe (19) sind, durch Anpassung des Korrekturparameters (16, 17) minimiert wird,
wobei die Korrekturinformation (1) den wenigstens einen jeweiligen Korrekturparameter (20) für die jeweilige Gradientenrichtung (5, 6) umfasst oder von diesem abhängt.

7. Computerimplementiertes Verfahren nach einem der Ansprüche 4 bis 6, **dadurch gekennzeichnet, dass** für den jeweiligen Referenzpunkt (10) zusätzlich auf Basis der ersten und/oder zweiten Magnetresonanzdaten (7, 8) die oder eine Amplitude (26, 27) des Magnetresonanzsignals am jeweiligen Referenzpunkt (10) ermittelt wird, wobei die Untergruppe der Schichten (21) in Abhängigkeit der Amplituden (26, 27) der Referenzpunkte (10) in der jeweiligen Messschicht (21) ausgewählt wird.

8. Computerimplementiertes Verfahren nach einem der vorangehenden Ansprüche, **dadurch gekennzeichnet, dass** die Phasendifferenzen (9) für Referenzpunkte (10) in mehreren Messschichten (21) ermittelt werden, indem bei der Erfassung der jeweiligen ersten und zweiten Magnetresonanzdaten (7, 8) zusätzlich eine Phasenkodierung in die oder eine Schichtselektionsrichtung (31) genutzt wird, wodurch die ersten und zweiten Magnetresonanzdaten (7, 8) zunächst in Schichtselektionsrichtung (31) im Frequenzraum vorliegen, wonach durch eine Fouriertransformation der jeweiligen ersten und zweiten Messdaten (7, 8) in Schichtselektionsrichtung (31) für unterschiedliche Positionen (24) in Schichtselektionsrichtung (31) und somit unterschiedliche Messschichten (21) jeweils von den ersten Messdaten (7) abhängige erste Teilmessdaten (28) und von den zweiten Messdaten (8) abhängige zweite Teilmessdaten (29) für jede der Messschichten (21) vorliegen, wonach für die Referenzpunkte (10) entlang der jeweiligen Ortsraumlinie (11, 12) in der jeweiligen Messschicht (21) die ersten Phasen (13) des Magnetresonanzsignals auf Basis der jeweiligen ersten Teilmessdaten (28) und die zweiten Phasen (14) des Magnetresonanzsignals auf Basis der jeweiligen zweiten Teilmessdaten (29) ermittelt werden.

9. Computerimplementiertes Verfahren nach einem der vorangehenden Ansprüche, **dadurch gekennzeichnet, dass** für den jeweiligen Referenzpunkt (10) zusätzlich auf Basis der ersten und/oder zweiten Magnetresonanzdaten (7, 8) die oder eine Amplitude (26) des Magnetresonanzsignals am jeweiligen Referenzpunkt (10) ermittelt wird,
wobei einerseits ausschließlich Referenzpunkte (10) in die Untergruppe (19) der Referenzpunkte (10) aufgenommen werden, für die die Amplitude (26) einen Amplitudengrenzwert (30) erreicht oder überschreitet und/oder
wobei andererseits, bei einer Ermittlung der Phasendifferenzen (9) für Referenzpunkte (10) in mehreren in die oder eine Schichtselektionsrichtung (31) aufeinanderfolgenden Messschichten (21), Referenzpunkte (10), die auf einer jeweiligen Geraden in Schichtselektionsrichtung (31) liegen, ausschließlich dann in die Untergruppe (19) aufgenommen werden, wenn ein gemeinsamer Amplitudenwert, der auf Basis ihrer Amplituden (26) ermittelt wird, einen Gruppengrenzwert erreicht oder überschreitet.

10. Computerimplementiertes Verfahren nach einem der vorangehenden Ansprüche, **dadurch gekennzeichnet, dass** die Phasendifferenzen (9) für die jeweilige Ortsraumlinie durch einen Phasenkorrekturalgorithmus (32) ermittelt werden, der dazu eingerichtet ist, durch Analyse des Verlaufs der Differenz zwischen der ermittelten ersten und zweiten Phase (13, 14) entlang der jeweiligen Ortsraumlinie (11, 12) Phasensprünge aufgrund eines Phasenüberlaufs zu erkennen und zu korrigieren.

11. Computerimplementiertes Verfahren zur Rekonstruktion von Bilddaten (33) einer Magnetresonanzbildgebung in einem Untersuchungsvolumen (2), wobei Signalkurven (34) verarbeitet werden, die jeweils den Verlauf einer k-Raum-Amplitude und/oder einer k-Raum-Phase des Magnetresonanzsignals entlang einer k-Raum-Linie (35-37) in einem einer jeweiligen Messschicht (21) zugeordneten zweidimensionalen k-Raum (38) beschreiben, umfassend die Schritte:
- Fouriertransformation der jeweiligen Signalkurve (34) zur Bereitstellung einer jeweiligen Ortsraumkurve (39-41),
- lokales strecken und/oder stauchen der jeweiligen Ortsraumkurve (39-41), um eine jeweilige korrigierte Ortsraumkurve (42) bereitzustellen, wobei der lokale Grad der Stauchung (43) und/oder Streckung (44) in Abhängigkeit einer ortsabhängigen Korrekturinformation (1) vorgegeben wird, die Feldinhomogenitäten des Magnetfeldes in dem Untersuchungsvolumen (2) betrifft, die durch das Beaufschlagen des Untersuchungsvolumens (2) mit einem Magnetfeldgradienten (3, 4) resultieren,
- Fouriertransformation der jeweiligen korrigierten Ortsraumkurve (42) zur Bereitstellung einer jeweiligen korrigierten Signalkurve (45), und
- Rekonstruktion der Bilddaten (33) auf Basis der korrigierten Signalkurven (45).

12. Computerimplementiertes Verfahren nach Anspruch 11,
**dadurch gekennzeichnet, dass** die Korrekturinformation erste Korrekturgrößen (46) für eine erste k-Raum-Richtung (48) und zweite Korrekturgrößen (47) für eine gewinkelt zu der ersten k-Raum-Richtung (48) stehende zweite k-Raum-Richtung (49) vorgibt, wobei der lokale Grad der Stauchung (43) und/oder Streckung (44), der im Rahmen der Ermittlung der korrigierten Signalkurve (45) für wenigstens eine der k-Raum-Linien (35-37), die gewinkelt zu der ersten und zweiten k-Raum-Richtung (48, 49) verläuft, genutzt wird, in Abhängigkeit von interpolierten Korrekturgrößen (50) ermittelt wird, die jeweils als gewichtete Summe einer der ersten und einer der zweiten Korrekturgrößen (46, 47) ermittelt werden.

13. Computerimplementiertes Verfahren nach einem der vorangehenden Ansprüche, **dadurch gekennzeichnet, dass** Bilddaten für mehrere Messschichten (21) rekonstruiert werden, wobei Messdaten (51) verarbeitet werden, bei deren Erfassung zusätzlich eine Phasenkodierung in eine Schichtselektionsrichtung (31) genutzt wird, wodurch die Messdaten in Schichtselektionsrichtung (31) im Frequenzraum vorliegen, wonach durch eine Fouriertransformation der jeweiligen Messdaten (51) in Schichtselektionsrichtung (31) für unterschiedliche Positionen (24) in Schichtselektionsrichtung (31) und somit für unterschiedliche Messschichten (21) die Signalkurven (34) bereitgestellt werden.

14. Verarbeitungsvorrichtung, **dadurch gekennzeichnet, dass** sie zur Durchführung des computerimplementierten Verfahrens nach einem der vorangehenden Ansprüche eingerichtet ist.

15. Computerprogramm, umfassend Programmanweisungen, die dazu ausgebildet sind, das computerimplementierte Verfahren nach einem der Ansprüche 1 bis 13 zu implementieren, wenn sie auf einer Datenverarbeitungseinrichtung (53) ausgeführt werden.
